# EUROPÄISCHE PATENTSCHRIFT

(11) **EP 2 194 395 B1**
(45) Veröffentlichungstag und Bekanntmachung des Hinweises auf die Patenterteilung: **15.05.2013**
(21) Anmeldenummer: 09173095.2
(22) Anmeldetag: 15.10.2009
(51) Int. Cl.: G01S 7/03, G01S 7/35, G01S 13/02, H03L 7/07

(54) **Modulares Radarsystem**
Modular radar system
Système de radar modulaire

(30) Priorität: 04.12.2008 DE 102008044355
(43) Veröffentlichungstag der Anmeldung: 09.06.2010
(73) Patentinhaber: Robert Bosch GmbH, 70442 Stuttgart (DE)
(72) Erfinder: Himmelstoss, Armin, 71554 Weissach Im Tal (DE); Hauk, Joachim, 71272 Renningen-Malmsheim (DE); Steinbuch, Dirk, 71299 Wimsheim (DE)

(56) Entgegenhaltungen:
- GB-A- 2 356 989
- US-A1- 2006 197 699
- LARRY D'ADDARIO: "ALMA Project Book, Chapter 7, Local Oscillators" 12. Januar 2002 (2002-01-12), , XP007912074 * Abbildung 8 *
- Mark R. Kühn: "Subharmonische Injektionssynchronisation aktiver Antennenarrays" 2004, Fakultät für Elektrotechnik und Informationstechnik , Technische Universität München , München , XP007912075 * Abbildung 3.1 *

## Beschreibung

Die Erfindung betrifft ein Radarsystem, das mindestens zwei Module umfasst, die jeweils einen Phasendetektor und jeweils eine erste Hochfrequenzquelle und jeweils einen Antennenausgang und/oder jeweils eine oder mehrere Antennen aufweisen. Mindestens zwei Module umfassen eine Vorrichtung zur Synchronisation zwischen der ersten Hochfrequenzquelle eines ersten der mindestens zwei Module und der ersten Hochfrequenzquelle eines zweiten der mindestens zwei Module des Radarsystems. Der Phasendetektor weist jeweils einen ersten Eingang für ein erstes Referenzsignal auf. Außerdem betrifft die Erfindung ein Modul für ein Radarsystem.

Radarsender von Radarsensoren werden mit einer Hochfrequenzquelle (einem Oszillator) betrieben. Die Hochfrequenzquelle arbeitet entweder direkt auf der abzustrahlenden Frequenz in einer Regelschleife oder arbeitet auf einer niedrigeren Frequenz, die durch Vervielfachung auf die abzustrahlende Frequenz multipliziert wird. Zur Verteilung der Sendeleistung für Long Range Radar (LRR), Medium Range Radar (MRR) und Short Range Radar (SRR) sind folgende zwei Techniken bekannt. Es kann ein Einstrahl-Radar mit elektro-mechanischer Strahlschwenkeinrichtung zur Anwendung kommen und/oder ein passives Verteilnetz. Im letzteren Fall können zusätzlich Verstärker vorgesehen sein, um Verteilverluste auszugleichen.

WO2007/052247A2 beschreibt ein Radarsystem für automatisches Fahren, in dem ein Verteiler dazu vorgesehen ist, ein Referenzsignal auf vier Sender-Empfänger-Einheiten zu verteilen. Jede Sende-Empfänger-Einheit umfasst vier Antennenausgänge für je eine Antenne eines Phased-array-Antennenfeldes. Jede Antenne wird durch einen eigenen phase-scanned injection-locked Pushpush-Oszillator (PS-IPPO) mit Sendeleistung versorgt. Die Phase eines jeden der PS-IPPO wird im Ziehbereich mittels einer Kaskade von vorgeschalteten PS-IPPO mit einem Referenzsignal aus einem Referenzsignalgenerator synchroni siert. Außerhalb seines Ziehbereichs ist der jeweilige PS-IPPO ein freilaufender Oszillator. Injection-locked Oszillatoren haben unter anderem den Nachteil, dass ein Zeitverhalten des Nachführens des Oszillators schlecht beeinflusst werden kann.

US 2006/0197699 A1 zeigt eine Radareinrichtung mit mehreren gleichartigen Modulen, von denen jedes eine Antenne der Radareinrichtung ansteuert. Alle Module erhalten einen einheitlichen Takt von einem Referenz-Taktgenerator.

Es ist eine Aufgabe der vorliegenden Erfindung, ein gattungsgemäßes modulares Radarsystem bereitzustellen, das eine Beeinflussung des Zeitverhaltens im Nachführen des Oszillators erleichtert. Darüber hinaus ist es eine Aufgabe der Erfindung, ein Modul für ein Radarsystem mit diesem Vorteil bereitzustellen. Diese Aufgabe wird mit den Merkmalen der unabhängigen Ansprüche gelöst. Vorteilhafte Ausführungsformen der Erfindung sind in den abhängigen Ansprüchen angegeben.

Die Erfindung baut auf dem gattungsgemäßen Radarsystem dadurch auf, dass der Phasendetektor jeweils einen zweiten Eingang für ein erstes Schleifensignal, insbesondere für ein erstes Schleifensignal einer Phasenregelschleife (Phase Locked Loop, PLL), aufweist. Insbesondere kann so eine frequenz- und/oder phasenstarre Kopplung der Oszillatoren erfolgen. Auch können die für das erfindungsgemäße Radarsystem verwendeten Antennensysteme einen unveränderlichen oder zumindest nicht kontinuierlich veränderbaren Erfassungswinkel bzw. - richtung aufweisen. Die in gattungsgemäßen Radarsystemen verwendeten Modulationsarten sind in der Regel FM-basiert, wie FMCW, stepped-FM, stepped-CW, Multiplex-FM oder Mehrfrequenz-Modulationen (FM = Frequency Modulation; FMCW = Frequency Modulated Continuous Wave).
Ferner weist das Modul jeweils eine zweite Hochfrequenzquelle und jeweils einen Mischer auf, der einen ersten Eingang für ein zweites Schleifensignal der Phasenregelschleife aufweist, wobei an einem zweiten Eingang des Mischers ein Ausgang der zweiten Hochfrequenzquelle angeschlossen ist.

Außerdem weist das Modul jeweils eine Vorrichtung zur Bereitstellung eines Synchronisationssignals für ein nachfolgendes der Module auf.

In einer vorteilhaften Ausführungsform weist die zweite Hochfrequenzquelle einen Eingang für ein zweites Referenzsignal auf.

Eine andere bevorzugte Ausführungsform sieht vor, dass das Modul jeweils einen Busanschluss zur Steuerung des Moduls und/oder jeweils eine Ladungspumpe und/oder jeweils ein Filter und/oder jeweils einen ersten Frequenzteiler und/oder jeweils einen Frequenzvervielfacher und/oder jeweils einen Hochfrequenzleistungsverstärker umfasst.

Eine weitere Ausführungsform sieht vor, dass die Module des Radarsystems einen identischen Aufbau haben.

Außerdem baut die Erfindung auf einem gattungsgemäßen Modul für ein Radarsystem dadurch auf, dass das Modul den Aufbau eines der Module eines der oben beschriebenen Ausführungsformen des Radarsystems aufweist.

Die Erfindung wird nun mit Bezug auf die begleitenden Figuren anhand besonders bevorzugter Ausführungsformen erläutert.

Es zeigen:
- Fig. 1: ein schematisches Blockschaltbild einer ersten Ausführungsform des erfindungsgemäßen Radarsystems;
- Fig. 2: ein schematisches Blocksschaltbild einer ersten Hochfrequenzquelle der ersten, zweiten oder dritten Ausführungsform des erfindungsgemäßen Radarsystems;
- Fig. 3: ein schematisches Blocksschaltbild einer zweiten Ausführungsform des erfindungsgemäßen Radarsystems; und
- Fig. 4: ein schematisches Blockschaltbild einer dritten Ausführungsform des erfindungsgemäßen Radarsystems.

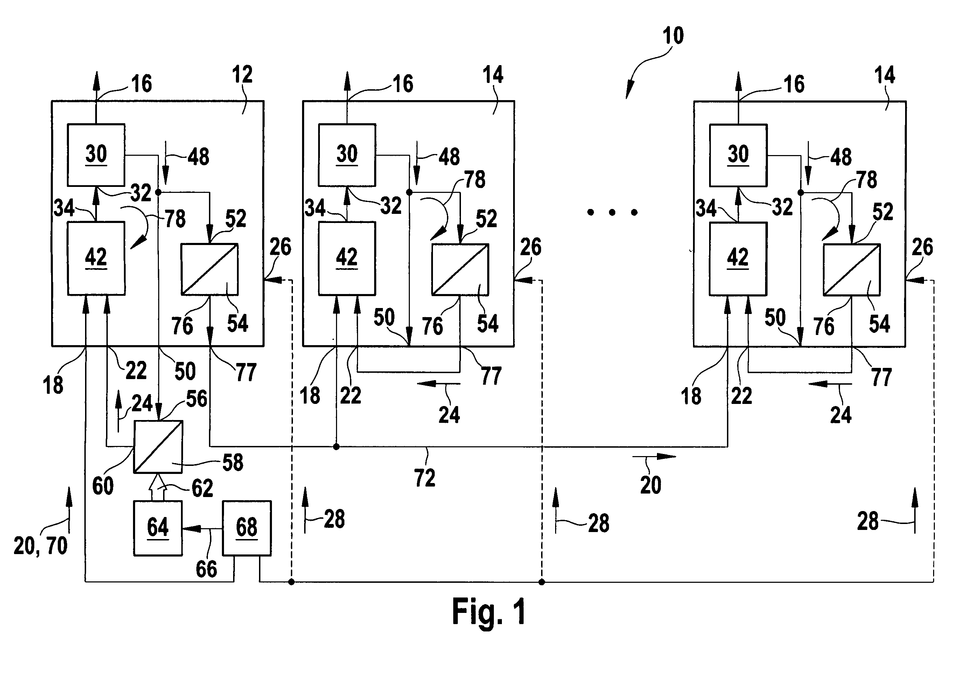

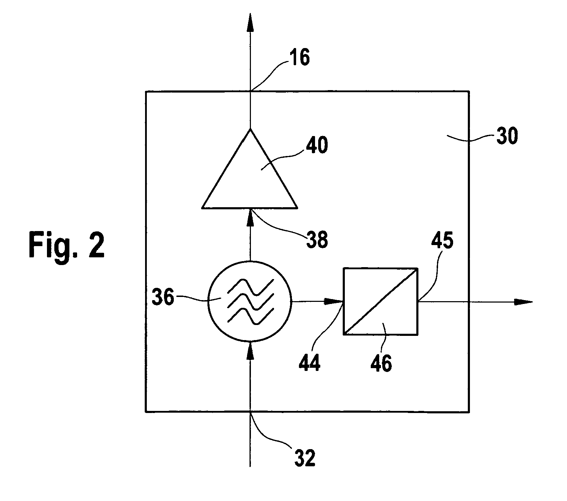

Fig. 1 zeigt ein schematisches Blockschaltbild einer ersten Ausführungsform des erfindungsgemäßen Radarsystems 10. Das Radarsystem 10 umfasst mehrere identisch aufgebaute Module 12, 14 (Radarsystemmodule; Hochfrequenz--Module). Jedes der Module 12, 14 weist einen Ausgangsanschluss 16 für eine Sendeantenne, sowie einen Eingangsanschluss 18 für ein Referenzsignal 20 und einen Eingangsanschluss 22 für ein erstes Schleifensignal 24 auf. Optional ist auch jeweils ein Eingang 26 für ein zentrales Taktsignal 28 vorgesehen. Jedes der Module 12, 14 umfasst eine erste Hochfrequenzquelle 30, deren schematisches Blockschaltbild Fig. 2 zeigt. Die erste Hochfrequenzquelle 30 umfasst einen spannungsgesteuerten Hochfrequenzoszillator 36 (VCO), der einen Eingang 32 zur Vorgabe der zu erzeugenden Frequenz aufweist und eine hochfrequente Spannung dem Eingang 38 eines Ausgangsverstärkers 40 bereitstellt. Der Eingang 32 der ersten Hochfrequenzquelle 30 zur Vorgabe der zu erzeugenden Frequenz ist an einen Ausgang 34 einer- dem Fachmann geläufigen - Frequenzsteuerungskomponente 42 angeschlossen, die einen Phasendetektor, eine Ladungspumpe und ein Filter umfasst. Der Ausgangsverstärker 40 gibt das verstärkte hochfrequente Sendesignal auf den Antennenausgang 16 aus. Außerdem leitet der Hochfrequenzoszillator 36 oder der Ausgangsverstärker 40 das hochfrequente Signal an einen Eingang 44 eines ersten Frequenzteilers 46 weiter. Ein Ausgang 45 des ersten Frequenzteilers 46 stellt ein zweites Schleifensignal 48 bereit, das zu einem Schleifenausgang 50 des Moduls 12, 14 und zu einem Eingang 52 eines zweiten Frequenzteilers 54 geführt wird. Der Schleifenausgang 50 des Master-Moduls 12 ist mit einem Schleifeneingang 56 eines dritten Frequenzteilers 58 verbunden. Ein erster Ausgang 60 des dritten Frequenzteilers 58 ist mit dem Schleifeneingang 22 des Master-Moduls 12 verbunden. Der Schleifeneingang 22 eines jeden Moduls 12, 14 führt zu einem Schleifeneingang der Frequenzsteuerungskomponente 42 des jeweiligen Moduls 12, 14. Ein Teilungsverhältnis des dritten Frequenzteilers 58 ist mittels eines Mikrocontrollers 64 oder mittels eines programmierbaren integrierten Schaltkreises 64 (field programmable array, FPGA) einstellbar. Der Mikrocontroller 64 bzw. FPGA 64 ist mittels eines seriellen oder parallen Datenbus 62 an dem dritten Frequenzteiler 58 angeschlossen. Der Mikrocontroller 64 bzw. FPGA 64 wird von einem Taktgeber 68 mit einem ersten Taktsignal 66 versorgt. Ein zweites Taktsignal 70 wird von dem Taktgeber 68 zu dem Referenzsignaleingang 18 des Master-Moduls 12 geführt. Ein Referenzsignal 20 für die Referenzsignaleingänge 18 der Slave-Module 14 wird über Referenzsignalleitung 72 von dem Schleifenausgang 76 eines zweiten Frequenzteilers 54 des Master-Moduls 12 über einen Modulanschluss 77 bereitgestellt. Der Schleifeneingang 22 eines jeden Slave-Moduls 14 ist mit einem Schleifenausgang 76 des zweiten Frequenzteilers 54 des jeweiligen selben Slave-Moduls 14 verbindbar, und zwar modulintern oder über Modulanschlüsse 77, 22 geschleift.

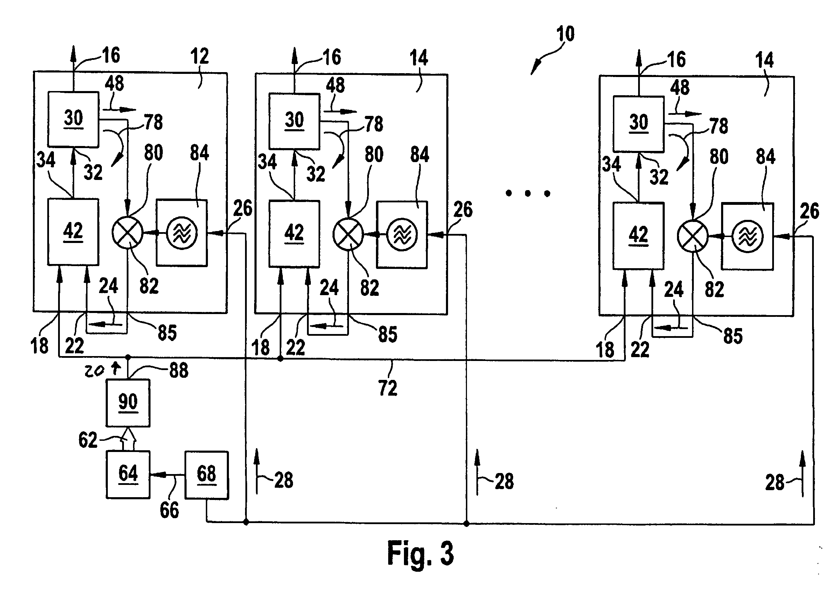

Fig. 3 zeigt ein schematisches Blockschaltbild einer zweiten Ausführungsform des erfindungsgemäßen Radarsystems 10. Das Radarsystem 10 umfasst mehrere identisch aufgebaute Module 12, 14 (Radarsystemmodule; Hochfrequenzmodule). Jedes der Module 12, 14 weist einen Ausgangsanschluss 16 für eine Sendeantenne, sowie einen Eingangsanschluss 18 für ein Referenzsignal 20 und einen Eingangsanschluss 22 für ein erstes Schleifensignal 24 auf. Jedes der Module 12, 14 weist einen Eingang 26 für ein zentrales Taktsignal 28 auf. Jedes der Module 12, 14 umfasst eine erste Hochfrequenzquelle 30 und eine Frequenzsteuerungskomponente 42, deren Zusammenwirken und jeweiliger Aufbau oben beschrieben wurde. Der Ausgangsverstärker 40 gibt das verstärkte hochfrequente Sendesignal auf den Antennenausgang 16 aus. Ein zweites Schleifensignal 48 von einem Ausgang 45 des ersten Frequenzteilers 46 wird zu einem ersten Eingang 80 eines Mischers 82 geführt. An dem Mischer 82 ist jeweils eine zweite Hochfrequenzquelle 84 angeschlossen, wobei die zweiten Hochfrequenzquellen 84 der Module 12, 14 mittels eines gemeinsamen Taktsignals 28 von einem Taktgeber 68 des Radersystems 10 synchronisiert werden. Ein Mischprodukt des Mischers 82 des jeweiligen Moduls 12, 14 wird dem Schleifeneingang 22 des jeweils selben Moduls 12, 14 zugeführt, und zwar modulintern oder über Modulanschlüsse 85, 22 geschleift. Der Schleifeneingang 22 des Moduls 12, 14 führt zu einem Schleifeneingang der Frequenzsteuerungskomponente 42. Das Referenzsignal 20 für die Referenzsignaleingänge 18 des Master-Moduls 12 und der Slave-Module 14 wird über eine Referenzsignalleitung 72 von einem Modulatorausgang 88 eines Modulators 90 (Modulations-Moduls) bereitgestellt. Eine Modulation des Modulators 90 ist mittels eines Mikrocontrollers 64 oder mittels eines programmierbaren integrierten Schaltkreises 64 (field programmable array, FPGA) einstellbar. Der Mikrocontroller 64 bzw. FPGA 64 ist mittels eines seriellen oder parallen Datenbus 62 an dem Modulator 90 angeschlossen. Der Mikrocontroller bzw. FPGA 64 und/oder der Modulator 90 werden von dem Taktgeber 68 mit einem ersten Taktsignal 66 versorgt. Der Modulator 90 liefert eine frequenzmodulierte oder konstante Referenzfrequenz. Diese Referenzfrequenz liegt üblicherweise in einem Bereich zwischen 10 MHz und 3 GHz und wird üblicherweise mit einer HF-Streifenleitung auf einem Substrat zu den Modulen 12, 14 geführt. Die identischen Module 12, 14 dienen einer phasenstarren Hochsetzung der Referenzfrequenz auf die Sendefrequenz. Die Hochsetzung der Referenzfrequenz erfolgt mittels einer Offset-Phasenregelschleife 78, die einen dielektrischen Resonator 84 (dielectric resonator oscillator, DRO) umfasst.

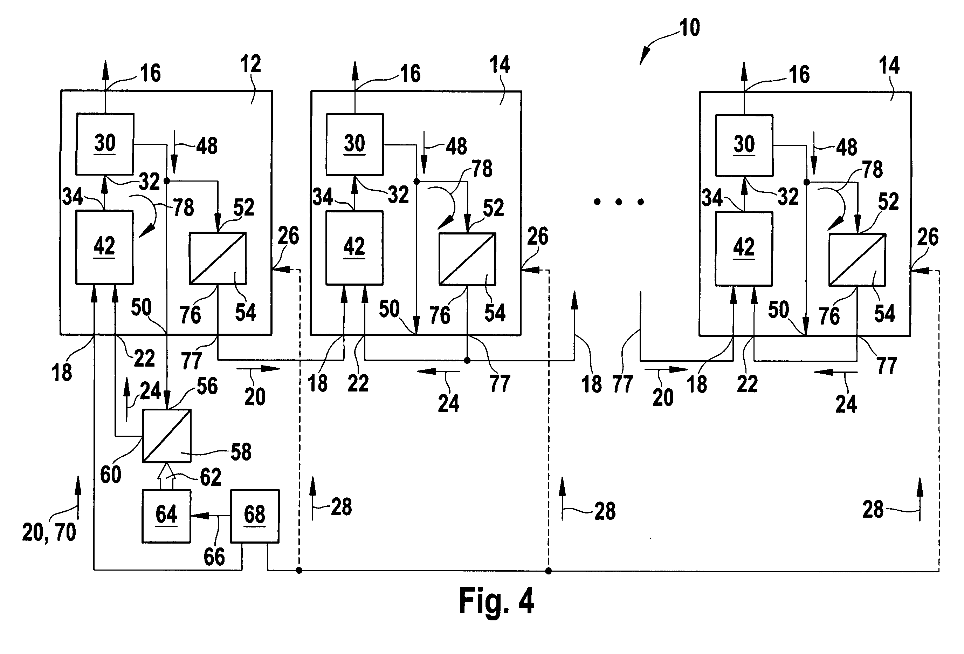

Fig. 4 zeigt ein schematisches Blockschaltbild einer dritten Ausführungsform des erfindungsgemäßen Radarsystems 10. Das Radarsystem 10 umfasst mehrere identisch aufgebaute Module 12, 14 (Radarsystemmodule). Jedes der Module 12, 14 weist einen Ausgangsanschluss 16 für eine Sendeantenne, sowie einen Eingangsanschluss 18 für ein Referenzsignal 20 und einen Eingangsanschluss 22 für ein erstes Schleifensignal 24 auf. Optional weist jedes der Module 12, 14 einen Eingang 26 für ein zentrales Taktsignal 28 auf. Jedes der Module 12, 14 umfasst eine erste Hochfrequenzquelle 30 und eine Frequenzsteuerungskomponente 42, deren Zusammenwirken und jeweiliger Aufbau oben beschrieben wurde. Der Ausgangsverstärker 40 gibt das verstärkte hochfrequente Sendesignal auf den Antennenausgang 16 aus. Ein zweites Schleifensignal 48 von einem Ausgang 45 des ersten Frequenzteilers 46 wird zu einem Schleifenausgang 50 des Moduls 12, 14 und zu einem ersten Eingang 52 eines zweiten Frequenzteilers 54 geführt. An dem Ausgang 76 des zweiten Frequenzteilers 54 ist jeweils der Referenzsignaleingang 18 eines nachfolgenden Slave-Moduls 14 angeschlossen, soweit es sich nicht um ein letztes der Kette jeweils nachfolgender Module 12, 14 handelt. Im entarteten Fall gibt es nur ein Slave-Modul 14. Das erste Modul 12 der Kette von Modulen 12, 14 ist ein Master-Modul 12. Bei allen Slave-Modulen 14 ist ein Ausgang 76 des zweiten Frequenzteilers 54 mit einem Schleifeneingang 22 des jeweils selben Moduls 14 verbunden, und zwar modulintern oder über Modulanschlüsse 77, 22 geschleift. Der Schleifeneingang 22 des Moduls 12, 14 führt zu einem Schleifeneingang der Frequenzsteuerungskomponente 42. Ein erster Ausgang 60 des dritten Frequenzteilers 58 ist mit dem Schleifeneingang 22 des Master-Moduls 12 verbunden. Ein Teilungsverhältnis des dritten Frequenzteilers 58 ist mittels eines Mikrocontrollers 64 oder mittels eines FPGA 64 einstellbar. Der Mikrocontroller 64 bzw. FPGA 64 ist mittels eines seriellen oder parallen Datenbus 62 an dem dritten Frequenzteiler 58 angeschlossen. Der Mikrocontroller 64 wird von einem Taktgeber 68 mit einem ersten Taktsignal 66 versorgt. Ein zweites Taktsignal 70 wird von dem Taktgeber 68 zu einem Referenzsignaleingang 18 des Master-Moduls 12 geführt. Der Schleifeneingang 22 eines jeden Slave-Moduls 14 ist mit dem Schleifenausgang 76 des zweiten Frequenzteilers 54 des jeweiligen selben Slave-Moduls 14 verbunden, und zwar modulintern oder über Modulanschlüsse 77, 22 geschleift.

Die Signalverteilung auf die Slave-Module 14 erfolgt also entweder - wie in Fig. 3 - von einem (modulierten) Master-Modul 12 aus oder kann, je nach Modulations- und Phasenanforderungen, durch einen internen zweiten 54 oder externen dritten 58 Frequenzteiler erfolgen, die jeweils vorzugsweise programmierbar sind. Eine durch Frequenzteiler 54, 58 heruntergeteilte Frequenz (Regel-Zwischenfrequenz) wird in kaskadierter oder paralleler Weise weiteren Modulen 14 zugeführt. Fig. 1 und 4 zeigen Ausführungsformen, in denen die Hochsetzung der Regel-Zwischenfrequenz in den nachfolgenden, angekoppelten Modulen 14 mittels einer Phasenregelschleife 78 erfolgt, in der die Modulation mittels eines externen programmierbaren dritten Frequenzteilers 58 durchgeführt wird. Fig. 3 zeigt eine Ausführungsform mit einer Offset-Phasenregelschleife 78. In allen Ausführungsformen ist der jeweilige Leistungsverstärker 40 vorzugsweise in das jeweilige Modul integriert.

## Patentansprüche

1. Radarsystem (10),
- das mindestens zwei Module (12, 14) umfasst, die jeweils einen Phasendetektor (42) und jeweils eine erste Hochfrequenzquelle (30) und jeweils einen Antennenausgang (16) und/oder jeweils eine oder mehrere Antennen aufweisen,
- wobei mindestens zwei Module (12, 14) eine Vorrichtung (18) zur Synchronisation zwischen der ersten Hochfrequenzquelle (30) eines ersten (12) der mindestens zwei Module (12, 14) und der ersten Hochfrequenzquelle (30) eines zweiten (14) der mindestens zwei Module (12, 14) des Radarsystems (10) umfassen,
- wobei der Phasendetektor (42) jeweils einen ersten Eingang (18) für ein erstes Referenzsignal (20) aufweist,
- wobei der Phasendetektor (42) jeweils einen zweiten Eingang (22) für ein erstes Schleifensignal (24), einer Phasenregelschleife (78), aufweist,
**dadurch gekennzeichnet, dass**
- das Modul (12, 14) jeweils eine zweite Hochfrequenzquelle (84) und jeweils einen Mischer (82) aufweist, der einen ersten Eingang (80) für ein zweites Schleifensignal (48) der Phasenregelsschleife (78) aufweist,
- wobei an einem zweiten Eingang (80) des Mischers (82) ein Ausgang der zweiten Hochfrequenzquelle (84) angeschlossen ist, und
- wobei das Modul (12, 14) jeweils eine Vorrichtung (54) zur Bereitstellung eines Synchronisationssignals (20) für ein nachfolgendes der Module (14) aufweist.

2. Radarsystem (10) gemäß Anspruch 1, **dadurch gekennzeichnet, dass** die zweite Hochfrequenzquelle (84) einen Eingang (26) für ein zweites Referenzsignal (28) aufweist.

3. Radarsystem (10) gemäß einem der Ansprüche 1 oder 2, **dadurch gekennzeichnet, dass** das Modul (12, 14) jeweils einen Busanschluss zur Steuerung des Moduls (12, 14) und/oder jeweils eine Ladungspumpe (42) und/oder jeweils ein Filter (42) und/oder jeweils einen ersten Frequenzteiler (46) und/oder jeweils einen Frequenzvervielfacher und/oder jeweils einen Hochfrequenzleistungsverstärker (40) umfasst.

4. Radarsystem (10) gemäß einem der vorangehenden Ansprüche, **dadurch gekennzeichnet, dass** die Module (12, 14) des Radarsystems (10) einen identischen Aufbau haben.

5. Modul (12, 14) für ein Radarsystem (10), **dadurch gekennzeichnet, dass** das Modul (12, 14) den Aufbau eines der Module (12, 14) des Radarsystems (10) gemäß einem der Ansprüche 1 bis 3 aufweist.

## Claims

1. Radar system (10)
- comprising at least two modules (12, 14) which have in each case one phase detector (42) and in each case one first radio-frequency source (30) and in each case one antenna output (16) and/or in each case one or more antennas,
- wherein at least two modules (12, 14) comprise a device (18) for synchronization between the first radio-frequency source (30) of a first one (12) of the at least two modules (12, 14) and the first radio-frequency source (30) of a second one (14) of the at least two modules (12, 14) of the radar system (10),
- wherein the phase detector (42) has in each case a first input (18) for a first reference signal (20),
- wherein the phase detector (42) has in each case a second input (22) for a first loop signal (24) of a phase-locked loop (78),
**characterized in that**
- the module (12, 14) has in each case a second radio-frequency source (84) and in each case a mixer (82) which has a first input (80) for a second loop signal (48) of the phase-locked loop (78),
- wherein an output of the second radio-frequency source (84) is connected to a second input (80) of the mixer (82), and
- wherein the module (12, 14) has in each case a device (54) for providing a synchronization signal (20) for a subsequent one of the modules (14).

2. Radar system (10) according to Claim 1, **characterized in that** the second radio-frequency source (84) has an input (26) for a second reference signal (28).

3. Radar system (10) according to one of Claims 1 or 2, **characterized in that** the module (12, 14) comprises in each case a bus terminal for controlling the module (12, 14) and/or in each case a charge pump (42) and/or in each case a filter (42) and/or in each case a first frequency divider (46) and/or in each case a frequency multiplier and/or in each case a radio-frequency power amplifier (40).

4. Radar system (10) according to one of the preceding claims, **characterized in that** the modules (12, 14) of the radar system (10) have an identical configuration.

5. Module (12, 14) for a radar system (10), **characterized in that** the module (12, 14) has the configuration of one of the modules (12, 14) of the radar system (10) according to one of Claims 1 to 3.

## Revendications

1. Système de radar (10) :
comprenant au moins deux modules (12, 14) comportant respectivement un détecteur de phase (42) et respectivement une première source haute fréquence (30) et respectivement une sortie d'antenne (16) et/ou respectivement une ou plusieurs antennes, au moins deux modules (12, 14) comprenant un dispositif (18) de synchronisation entre la première source haute fréquence (30) d'un premier (12) des au moins deux modules (12, 14) et de la première source haute fréquence (30) d'un deuxième (14) des au moins deux modules (12, 14) du système de radar (10) ;
le détecteur de phase (42) comportant respectivement une première entrée (18) pour un premier signal de référence (20) ;
le détecteur de phase (42) comportant respectivement une deuxième entrée (22) pour un premier signal de boucle (24) d'une boucle de régulation de phase (78) ;
**caractérisé en ce que** :
le module (12, 14) comporte respectivement une deuxième source haute fréquence (84) et respectivement un mélangeur (82) comportant une première entrée (80) pour un deuxième signal de boucle (48) de la boucle de régulation de phase (78) ;
une sortie de la deuxième source haute fréquence (84) étant raccordée à une deuxième entrée (80) du mélangeur (82) ;
le module (12, 14) comportant respectivement un dispositif (54) de mise à disposition d'un signal de synchronisation (20) pour le module (14) suivant.

2. Système de radar (10) selon la revendication 1, **caractérisé en ce que** la deuxième source haute fréquence (84) comporte une entrée (26) pour un deuxième signal de référence (28).

3. Système de radar (10) selon l'une quelconque des revendications 1 ou 2, **caractérisé en ce que** le module (12, 14) comporte respectivement un branchement de bus pour commander le module (12, 14) et/ou respectivement une pompe de chargement (42) et/ou respectivement un filtre (42) et/ou respectivement un premier répartiteur de fréquence (46) et/ou respectivement un multiplicateur de fréquence et/ou respectivement un amplificateur de puissance de haute fréquence (40).

4. Système de radar (10) selon l'une quelconque des revendications précédentes, **caractérisé en ce que** les modules (12, 14) du système de radar (10) ont une structure identique.

5. Module (12, 14) pour un système de radar (10), **caractérisé en ce que** le module (12, 14) présente la structure d'un des modules (12, 14) du système de radar (10) selon l'une quelconque des revendications 1 à 3.
